# EUROPEAN PATENT APPLICATION

(11) **EP 0 802 418 A2**
(43) Date of publication of application: **22.10.1997**
(21) Application number: 97105459.8
(22) Date of filing: 02.04.1997
(51) Int. Cl.: G01R 1/073, G01R 31/319

(54) **Method for high-speed testing a semiconductor device**

(30) Priority: 18.04.1996 US 634571
(71) Applicant: MOTOROLA, INC., Schaumburg, IL 60196 (US)
(72) Inventor: Wenzel, James F., Austin, Texas 78729 (US); Pyron, Carol, Austin, Texas 78749 (US); Belete, Dawit, Austin, Texas 78748 (US)
(74) Representative: Gibson, Sarah Jane

(57) **Abstract**

A method for high speed testing a semiconductor device, such as a processor (102), involves providing an array probe assembly (160) which includes a test substrate (164) having integrated circuits (104, 106) mounted thereon. A first subset of interconnects (112) of the test substrate electrically connect the integrated circuits to the device under test. A second subset of interconnects (116) electrically connect the device under test to an external tester (120). A third subset of interconnects (110) are used to electrically connect the integrated circuits to the external tester. Interconnects (110) are used to selectively communicate information in a high speed manner, while interconnects (112) are used to selectively communicate information in a low speed manner. Thus, the integrated circuits on the test substrate enable testing of a device at frequencies higher than the tester frequency, and further eliminate the need for pin-for-pin compatibility between the tester and the device under test.

## Description

### Field of the Invention

The present invention relates generally to the field of semiconductors and integrated circuits, and more specifically to methods for testing these devices.

### Background of the Invention

Semiconductor devices which include integrated circuitry are typically formed as a plurality of individual semiconductor die on a single semiconductor wafer. The individual die are singulated from the wafer, for example by sawing the wafer, and the die are then either packaged or mounted to a user's substrate.

Before going to the expense of packaging all die, and before shipping any unpackaged die to a customer, semiconductor manufacturers test the die in wafer form. Testing is usually accomplished by using a plurality of cantilever probes or array probes to connect the input and output (I/O) terminals of each die, and sending electrically signals through the probes using a tester.

A problem semiconductor manufacturers are experiencing with commercially available testers and probe equipment is that the tester speeds lag behind the operational speed of the semiconductor die being tested. For example, a high speed microprocessor may be capable at operating at 200 MHz, but the testers a semiconductor manufacturer has available may only execute a test program at 100 MHz or less. Not being able to test the devices "at speed" gives a manufacturer a false sense of security with the test results. Devices which pass test at wafer probe or final test when tested with slower speed testers may fail when put in a user's application and operated at speed.

Tester speed is continually improving with new models, but generally the incremental improvement from model to model is not sufficient to keep up with the speeds of the integrated circuits being designed by semiconductor manufacturers. Moreover, the design cycle time of new testers is quite long, such that soon after introduction into the market the testers are again slower that the integrated circuits they are designed to test. Nonetheless, the newest and fastest tester models are extremely expensive (currently about $5 Million). Thus, a semiconductor manufacturer must make a tremendous outlay of capital to test its own products, yet cannot be assured of the yield of these products even upon passing test due to the limitations of tester capability. This problem is particularly disconcerting for a semiconductor manufacturer trying to introduce a new, high speed integrated circuit product, where there is no history of how the part performs and where a customer itself is unsure of the capability of the product.

Another downfall associated with today's commercially available testers is that the testers require pin-for-pin compatibility with the device under test. For each pin or input/output (I/O) of the device under test, the tester must have a pin electronics card. With I/Os or pin counts of many high end semiconductor devices being several hundred in number, the requirement of pin-for-pin compatibility by the tester undesirably increases the cost of the tester.

Therefore, there is a need in the semiconductor industry for a new method for testing semiconductor devices, including integrated circuits, which enables testing at speed in a cost effective, timely manner.

### Brief Description of the Drawings

FIG. 1 is a cross-sectional illustration of an array probe assembly used to probe a bumped semiconductor wafer.

FIG. 2 is a top down view of a multichip module which is suitable for being tested in accordance with the present invention.

FIG. 3 is a table demonstrating a decrease in yield as operational frequency increases, and as multiple chips are included in one package.

FIG. 4 is a cross-sectional illustration of a probe assembly in accordance with the present invention used for testing a semiconductor wafer, wherein integrated circuits are included in the test assembly to test high speed interfaces of the device under test.

FIG. 5 is a cross-sectional view of the test assembly illustrated in FIG. 4 as it would appear during testing of the semiconductor wafer.

FIG. 6 is a process flow which includes steps for testing a device under test using a test substrate having an integrated circuit mounted thereon in accordance with the present invention.

FIG. 7 is an exploded view of a portion of the test assembly and semiconductor wafer of FIGs. 4 and 5, more particularly illustrating the electrical connections between the device under test, the test substrate, and the integrated circuit mounted on the test substrate.

FIG. 8 is a block diagram view of how communications occur between a tester, a device under test, and integrated circuits which are included on a test substrate.

### Detailed Description of a Preferred Embodiment

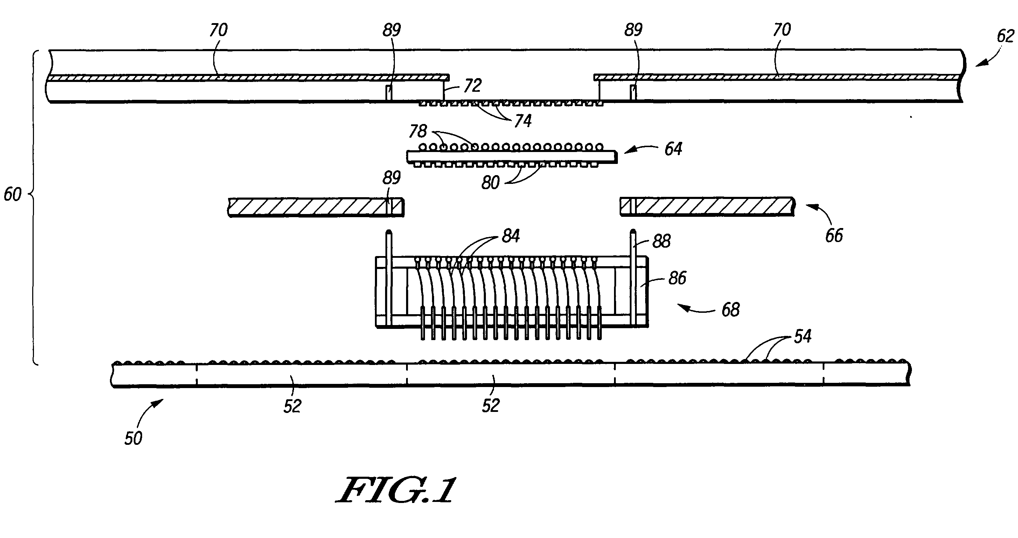

FIG. 1 is a cross sectional illustration of an array probe assembly 60 used in a known method for probing semiconductor wafers. The method in which probe assembly 60 is used to probe wafers is more fully explained in a co-pending, commonly assigned, patent application by Thomas F. Lum et al., Serial No. 08/236,847, filed May 2, 1994, and entitled, "METHOD FOR PROBING WAFERS." The entirety of this application is herein incorporated by reference , but a brief description of assembly 60 and how it is used to probe wafers follows.

As illustrated in FIG. 1, array probe assembly 60 is used to probe a semiconductor wafer 50 having a plurality of semiconductor die 52. Each semiconductor die 52 includes a plurality of conductive bumps 54, for example solder bumps formed by an evaporative metal deposition process known as Controlled Collapse Chip Connection (C4). While the focus of the description of probe assembly 60, and the description of a similar assembly suitable for practicing the present invention, is on methods for probing bumped semiconductor wafers, it understood that the assemblies can also be used to probe unbumped wafers. In other words, array probe assembly 60 may be used to directly probe pads on a semiconductor die as opposed to conductive bumps which may be formed on such pads. Furthermore, if conductive bumps are formed, the conductive bumps need not be C4 bumps but can be any other conductive bumps suitable for accessing the circuitry on the individual semiconductor die. Moreover, while assembly 60 has particular advantages in probing pads or bumps in an array configuration, the assembly can instead be designed to pads or bumps in a peripheral configuration around the perimeter of the die.

Array probe assembly 60 includes a probe card 62, a production package substrate 64, a mounting plate 66, and an array probe head 68. Probe card 62 is made of a conventional probe card material, for example a printed circuit board material. Probe card 62 includes a plurality of conductive traces 70 which are configured for use in a conventional tester (not shown in FIG. 1). Conductive traces 70 can be surface traces or internal traces such as illustrated in FIG. 1. If internal traces are used, probe card 62 will also include conductive vias or through-holes 72. While at one end conductive traces 70 are configured so as to make suitable connection to a tester, at the other end the conductive traces 70 are configured or routed to ultimately form a plurality of conductive pads 74. Conductive pads 74 formed on probe card 62 are arranged to match a corresponding configuration of conductive pads on production package substrate 64. The conductive traces, through-holes, and pads are formed on probe card 62 using conventional probe card manufacturing techniques.

Also included in array probe assembly 60 is a production package substrate 64. In one form, production package substrate 64 is made to be nearly identical to the package substrate in which the device under test will be packaged. By utilizing the same type of package substrate in the probe assembly as will be used in the final device package, test results more accurately reflect final performance of the device in a user's application. Furthermore, the use of the production package substrate in the probe assembly eliminates the tedious, manually intensive, and expensive hand-wiring used to connect array probe head 68 to probe card 62 in older probe assemblies.

On one side of production package substrate 64 of FIG. 1 is a plurality of conductive pads or conductive balls 78 which are configured to match the configuration of conductive pads 74 on probe card 62. As an alternative to conductive balls, a plurality of pins or other type of lead can be use to connect substrate 64 to probe card 62. On an opposing side of production package substrate 64 is a plurality of conductive pads 80 which are configured to match the configuration of conductive bumps 54 on each individual semiconductor die to be tested. The configuration of conductive balls 78 and conductive pads 80 can be the same, but is more likely to be different because the package substrate is usually used to fan-out the I/O pattern of the die to a less dense I/O pattern on the bottom of the package for mounting to a user's substrate. A more detailed description of production package substrate 64 is provided below.

Array probe head 68, is also included within array probe assembly 60. Array probe head 68 includes a plurality of probe wires 84 arranged in a configuration to match the conductive bumps 54 on the die to be tested. Due to the fragility of probe wires 84, the probe wires are encased within a housing 86 which substantially fixes the wires in the array configuration of the bumps on the die. However, the probe wires 84 are allowed to float primarily in a vertical direction to allow adequate connection to conductive bumps 54 on the die and production package substrate 64. To prevent electrical short circuiting, individual probe wires can be coated with an insulating layer and/or housing 86 can be made in part or in full of an insulating material.

During an actual wafer probing operation, the individual components of array probe assembly 60 are fit together. Array probe head 68 is brought into proximity with production package substrate 64 such that probe wires 84 are in contact with conductive pads 80 on the underside of the production pad substrate. To maintain the connection between the array probe head 68 and the production package substrate 64, guide pins 88 may be provided in the probe head, and extended through mounting plate 66 which separates the probe head from probe card 62. Mounting plate 66 has a thickness which maintains the appropriate distance between probe head 68 and probe card 62 to insure sufficient connection between probe wires 84 and conductive pads 80 of production package substrate 64. Guide pins 88 can extend through guide holes 89 both within mounting plate 66 and probe card 62 to insure proper alignment between the various components of array probe assembly 60.

Production package substrate 64 is also brought in contact with probe card 62 such that conductive pads or balls 78 of the production package substrate are in electrical contact with conductive pads 74 of the probe card. Whereas array probe head 68 is simply brought into proximity with production package substrate 64 to make electrical connection between the conductive pads 80 and the probe wires, production package substrate 64 is physically connected to probe card 62 through a surface mount process. Just like a final packaged product would be surfaced mounted to a user's printed circuit board, production package substrate 64 is likewise mounted to the probe card. Accordingly, it may be desirable to include conductive balls 78, rather than merely planar conductive pads, to facilitate the surface mount process. Production package substrate 64 will likely initially include a plurality of conductive pads on the upper surface as well as on the lower surface, but conductive balls, for example solder balls, can be subsequently attached to these upper surface pads (i.e. the surface adjacent the probe card). While in a preferred form production package substrate 64 is both physically and electrically connected to probe card 62, it is sufficient for the substrate to be in only electrical contact with the probe card. Furthermore, although the probe card 62, production package substrate 64, mounting plate 66, and array probe head 68 together make up array probe assembly 60, the various components need not be physically connected to one another. All that is required is sufficient electrical connection between the probe wires of the probe head, the conductive pads on the production package substrate, and the conductive traces on the probe card.

Mounting plate 66 is an optional feature to the assembly, but it is useful in maintaining proper spacing between the probe head and the probe card. Furthermore, mounting plate 66, which can be made of a rigid material, such as stainless or other alloyed steel, is used to maintain planarity of probe card 62, thereby insuring proper electrical connection between probe wires 84 and pads 80 on substrate 64. It is also noted that array probe head 68 can be replaced with other suitable means for connecting the conductive pads 80 on a surface of production package substrate 64 with the conductive bumps 54 of the semiconductor die. Moreover, it is envisioned that in the future production package substrate 64 can suffice as the only intervening member between probe card 62 and semiconductor wafer 50. In other words, it can be possible for conductive pads 80 on a surface of production package substrate 64 to be brought directly in contact with conductive bumps 54 on the die. An impediment to relying on pads 80 making direct contact to bumps 54 on the die is that the pads alone are generally insufficient to break a native oxide which can form on the bumps, whereas probe wires or probe needles are able to break through such an oxide by a scrubbing action to insure adequate electrical connections.

While array probe assembly 60 described above has the advantage of being able to test a semiconductor die in its packaged environment, such that the probing operation emulates the performance of a final package product, the probe assembly does not overcome the deficiencies of commercially available testers which can only operate at frequencies much less than the frequencies of the semiconductor devices being tested. Furthermore, the probe assembly does not eliminate the need to have pin-for-pin compatibility between the device under test and the tester.

Accordingly, there is a need for an improved method for testing semiconductors devices at their designed operating speeds. The present invention fulfills this need by testing devices using a probe assembly similar to that described above, but which includes an integrated circuit die. The device under test communicates with the integrated circuit die in the probe assembly at speeds faster than those which a commercially tester could communicate with the device under test. The integrated circuit in the probe assembly is then queried to see if the communications between it and the device under test were successfully performed. Thus, a device under test can be tested at its maximum speed, without being limited by the tester capability. Furthermore, the use of an integrated circuit in the probe assembly reduces the need for the tester to be pin-for-pin compatible with the device under test since some of the pins of the device under test are exercised with the integrated circuit rather than with the tester.

In one form of the invention, a tester transfers test vectors directly to the device under test through a subset of interconnects on a test substrate (which contains the integrated circuit) of probe assembly . The device under test then executes and begins communication with the integrated circuit on the test substrate through a second subset of the plurality of interconnects of the test substrate. Following execution, the integrated circuit on the test substrate writes back information either to the tester or to the device under test, and the information written back is analyzed to determine whether the device under test is operating as planned. Furthermore, analysis of the written data can be used determine the speed at which the device under test is operating, to enable devices under test to be speed sorted at the probing operation. The present invention can be implemented at either wafer probe, or at final test after the devices are packaged in the form to be sent to a user.

These and other features and advantages of the present invention will be more clearly understood from the following detailed description taken in conjunction with the accompanying drawings. It is important to point out that the illustrations are not necessarily drawn to scale and that there will likely be other embodiments of the present invention which are not specifically illustrated.

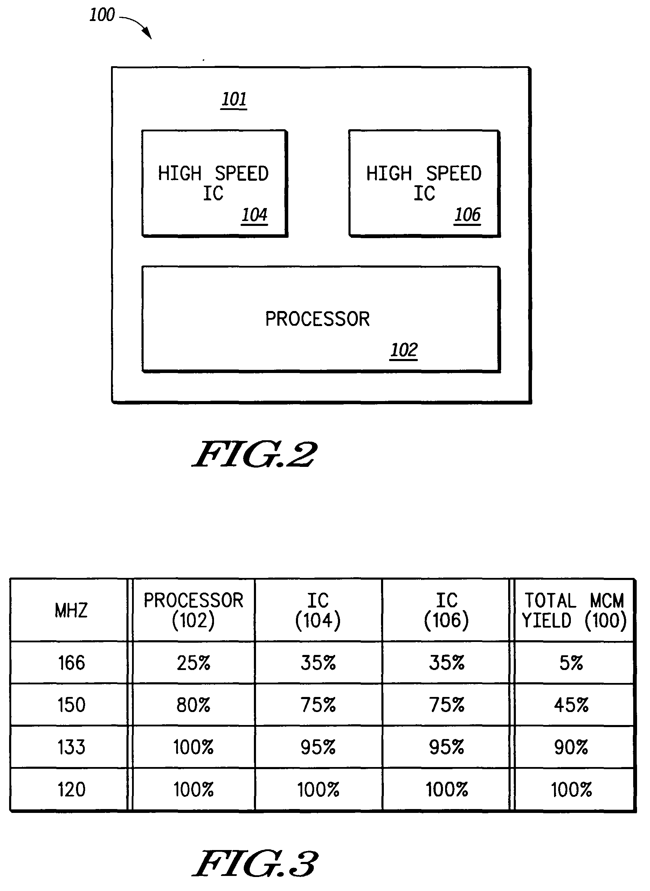

FIG. 2 illustrates a top down view of a multichip module 100 which includes three chips, namely a processor 102, a high speed integrated circuit 104, and a high speed integrated circuit 106. High speed integrated circuits can be, for example, memory devices such as fast static random access memories. As illustrated, each of these chips are flip-chip mounted to a substrate 101 of the multichip module, in other words the back or inactive side of the die is visible to the viewer, although other means of electrical connection between the chips to a substrate can be achieved. For instance, the die can be mounted active side up, with electrical connections being made with wire bonds.

A probe assembly, such as that described above in reference to FIG. 1, can be used to probe each of the chips of module while in wafer form. In using the probe assembly of FIG. 1, each of these chips are tested independently of the others. Furthermore, each of the chips tested using probe assembly 60 are tested at the speed in which the tester can send signals to the probe card, and therefore to the device under test. As discussed above, commercially available testers typically operate at frequencies much lower than the operating capabilities of the chips being tested. For example, what is considered in the industry as a high speed tester operates at a frequency of about 100 megahertz (MHz), whereas these testers are being used to test microprocessors that operate at up to 200 MHz.

Because the chips in multichip module 100 are not tested at the speeds at which they were designed to operate, the accuracy of the test results is in question. Typically, assumptions are made that if a device under test which is designed to operate at 200 MHz passes a functional test wherein the tester is capable of only operating at 100 MHz, the device is deemed to have passed functional test since a semiconductor manufacturer has no other way of functionally testing at speed. The assumptions made sometimes prove to be incorrect. In reality, upon implementing a device which passed testing into a system, the device in fact may fail when operated at its designed higher frequency. Accordingly, the actual yield of the device may be less than what the test results indicate.

If a device which passes test is included in a multichip module applications, the yields of each of the individual chips on the module must be taken into account to determine the overall yield for the module itself. The yield of a multichip module is a product of the yield of each of the individual components. Thus, the loss of yield due to having tested the devices at lower speeds is exacerbated upon putting the devices together on a module. These results are demonstrated in tabular form in FIG. 3. Individual yield percentages of processor 102, high speed integrated circuit 104, and high speed integrated circuit 106 are included in the table. The total yield of the multichip module which is formed to include one of each of the devices is calculated by multiplying the yield of each individual chip included in the module. As is clear from the table, as the speed of the chips increases, the yield of each individual die decreases. This phenomenon is typical of semiconductor manufacturing. As a result of the decrease in individuals device yield, the yield of the total multichip module decreases more dramatically since module yield is a product of individual chip yield.

The table of FIG. 3 can also be used to demonstrate yield after testing. A testing operation which tests the devices at 120 MHz will weed out "good die" from "bad die". After wafer probe, only devices which pass testing at 120 MHz are forwarded on the assembly operations. Thus, consider the after-test yield for devices at 120 MHz to be 100%, as FIG. 3 indicates. The total yield of the multichip module package to include each of these chips will also be 100%, barring any yield lost during the assembly operations. However, if in actual operation the devices of the multichip module are to operate at higher frequencies, such as 133 MHz, 150 MHz, or 166 MHz, the fact that the devices passed test at 120 MHz will not mean that they properly operate at the higher frequencies. The actual percentage of device which properly operate at these higher frequencies will decline, as the decline in yields in FIG. 3 indicate. In a worse case scenario in the table of FIG. 3, only 25% of the microprocessors which passed test at 120 MHz may actually operate at 166 MHz. Yet, because all these processors passed test, these processors will be packaged in a multichip module. Thus, only one-fourth of the multichip modules packaged will include 166 MHz processors. Combined with the fact that the additional chips included in the multichip modules will likewise have some fall-out when operated at higher frequencies, the total final yield of a multichip module at 166 MHz may be as low as 5%. (It is noted that the yields included in the table are the yields at the speeds indicated. Devices which do not yield at a higher frequency operation can often be sold as good devices at a lower frequency so that some value is still obtained.)

As the numbers in FIG. 3 demonstrate, the need to know the true yield (i.e. yield at speed) upon testing a semiconductor device is particularly important in multichip module applications so that the yield of the final modules can be maximized. However, existing tester capability lags behind the operation frequencies of the processors and other high speed devices being made by semiconductor manufacturers. In accordance with the present invention, device testing can be done at speed by utilizing an integrated circuit in the test assembly or probe assembly used to test the device. Communications between the device under test and the integrated circuit in the test assembly occur at the design frequencies of the chip, and are not limited by the tester frequencies. The results of the communications between the device under test and the integrated circuit of the test assembly are analyzed to see if the device is functioning properly at speeds higher than the tester frequency.

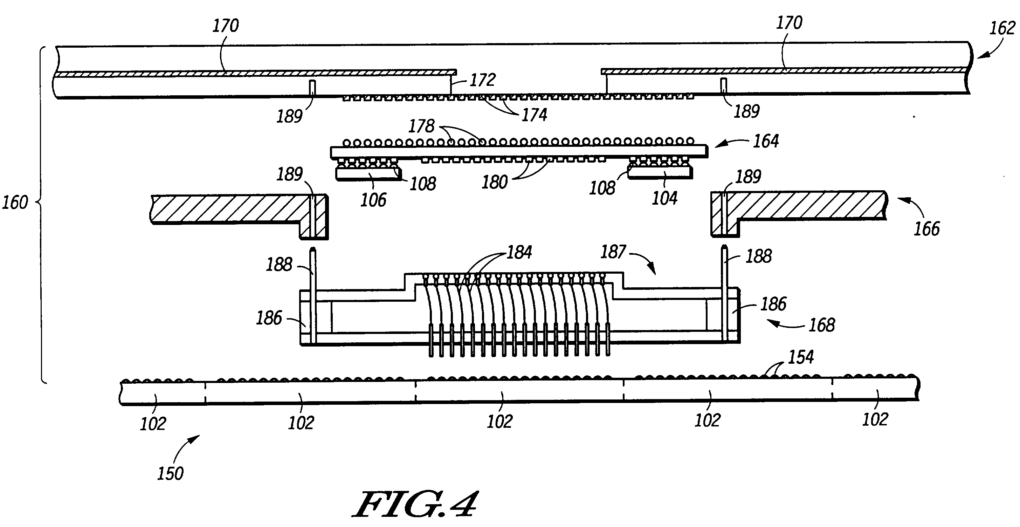

In one embodiment of the present invention, the integrated circuit chips are included in a test assembly much like that described in reference to FIG. 1. In one embodiment, testing is accomplished at the wafer level. More specifically, in reference to FIG. 4, a semiconductor wafer 150 includes a plurality of die, as illustrated a plurality of processors 102. The wafer is probed using a probe assembly 160. Probe assembly 160 includes many of the same features of probe assembly 60 described previously in reference to FIG. 1. For example, array probe assembly 160 includes a probe card 162 (also referred to as an interface board because it serves as an interface to a tester), a mounting plate 166, and an array probe head 168. In place of a production package substrate, array probe assembly 160 includes a test substrate 164. Test substrate 164 is like the production package substrate described above, but 1) includes at least one integrated circuit chip electrically connected thereto for testing high speed interfaces of the device under test, and 2) test substrate 164 is not necessarily the same substrate upon which the device under test is finally mounted or packaged. However, in a preferred embodiment, test substrate 164 is a multilayer ceramic substrate like those used for packaging semiconductor devices.

Like probe card 62, probe card 162 of a printed circuit board material and includes a plurality of conductive traces 170, a plurality of conductive pads 174, and a plurality of conductive through holes 172 to electrically connect the conductive traces to the conductive pads. The pattern and configuration of conductive pads 174 is designed to match the terminal configuration on the upper surface of test substrate 164 (i.e. the surface of the test substrate which will be attached to the probe card). Conductive traces 170 are routed from probe card 162 to a tester (not illustrated in FIG. 4) as is done in conventional testing apparatus.

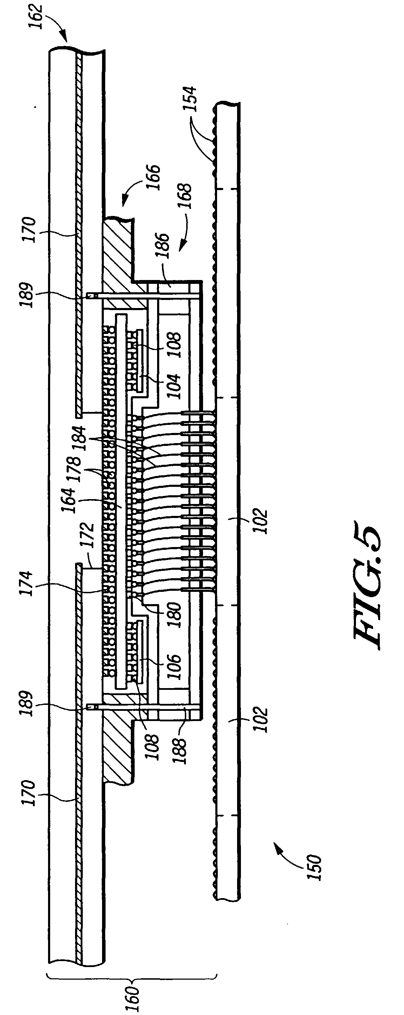

Test substrate 164, like production package substrate 64, includes a plurality of conductive pads 180, and a plurality of conductive pads or balls 178, which are connected to one another through a plurality of internal conductive interconnects (not illustrated in FIG. 4, see FIG. 5). One side of test substrate 164 includes the plurality of conductive balls 178 which is configured to match the configuration of conductive pads 174 on probe card 162. As an alternative to conductive balls, a plurality of pins or other type of lead can be used to connect test substrate 164 to probe card 162.

On an opposing side of test substrate 164 is the plurality of conductive pads 180 which are configured to 1) match the configuration of a plurality of conductive bumps 154 on each of processor 102, and 2) to match the configuration of the conductive bumps 108 on each of high speed integrated circuits 104 and 106. High speed integrated circuits 104 and 106 are permanently attached to test substrate 164, for example using a reflow operation to metallurgically bond solder bumps on the chips to pads on the test substrate. The bumps on integrated circuits 104 and 106 can be formed using the same technique used to form conductive bumps 154 on wafer 150, for example using C4. In one embodiment of the invention, the integrated circuit chips attached to the test substrate are one or more chips which will be included with the device under test in a multichip module. For example, as illustrated, test substrate 164 includes integrated circuits 104 and 106 which are included on multichip module 100 along with the processor 102 being tested.

In one embodiment of the present invention, the test substrate used in array probe assembly 160 is a ceramic substrate with multiple metal layers (at least on two opposing exterior surfaces, and likely to further have internal metal planes or lines). Conductive pads and traces on the substrate can be lithographically defined using conventional deposition and etching techniques. As one example, conventional gold plated copper metallization can be used on the substrate to form pads and traces. As an alternative, the material for test substrate 164 can be an epoxy reinforced with glass fibers or another organic material such as those used in printed circuit board applications to reduce the cost of the probe assembly. Like ceramic substrates, organic substrates can include multiple metallization layers both internal and external. Furthermore, the test substrate can be formed of a flex circuit or tape-like member which includes conductive traces and interconnects.

Array probe head 168 of probe assembly 160 is much like that described in reference to array probe assembly 60. Array probe head 168 includes a plurality of probe wires 184 and a housing 186. The wires within the probe head are protected by the housing but are free to move in a vertical direction so that the wires can make sufficient electrical contact with the device under test. The probe head also includes alignment pins 188 which are used to align the array probe head to both the probe card 162 and to test substrate 164. The alignment is provided by inserting alignment pins 188 through alignment holes 189 formed in both the probe card and through a mounting plate 166. Mounting plate 166 is provided in order to have a physical standoff between the array probe head 168 and the probe card 162, which is approximately equal to the total thickness of test substrate 164, including the thickness of integrated circuits 104 and 106.

One difference between array probe head 168 and that described previously in reference to FIG. 1, is that housing 186 must accommodate the presence of high speed integrated circuits 104 and 106 upon bringing the probe head, the test substrate, and the probe card together, as subsequently illustrated in FIG. 5. In one embodiment, integrated circuits 104 and 106 can be accommodated by providing a recessed area 187 in the housing of the array probe head for each chip. Upon bringing the individual components of the array probe assembly together, as illustrated in FIG. 5, integrated circuits 104 and 106 rest within these recesses, while probe wires 184 come into electrical contact with a portion of the plurality of conductive pads on one surface of test substrate 164. Alternatively, the housing of the probe head could be made small enough so that upon bringing the probe head into contact with the test substrate there is no interference with any chips on the test substrate.

As FIG. 5 also illustrates, during testing, wafer 150 is brought into proximity such that probe wires 184 come into physical and electrical contact with the conductive bumps 154 associated with the device under test (as illustrated processor 102). If the device under test is not bumped, the probe wires can be brought into contact with the I/O pads or terminals of the device under test. Once the probe wires are in contact with the device under test, the device can be tested by a tester (not illustrated) by transmitting electrical signals (in the form of test vectors) to the device through the probe assembly 160.

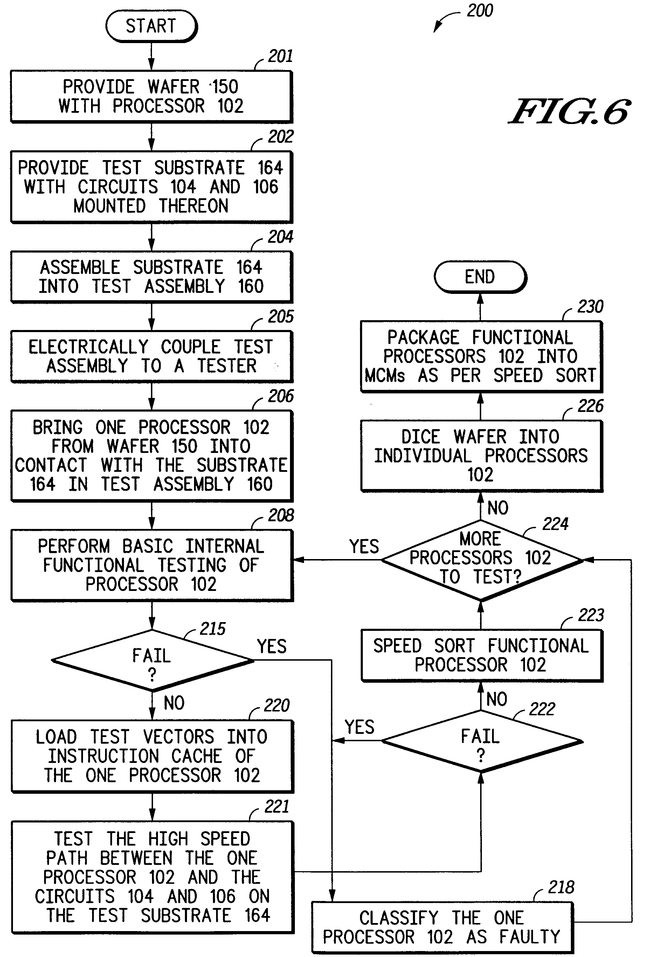

With a basic understanding of the individual elements of probe assembly 160 and their cooperation, a process of how such assembly can be used to high speed test a semiconductor device in accordance with the present invention will now be described in reference to a process flow 200 illustrated in FIG. 6. In understanding each of the individual steps in process flow 200, reference to other figures will be helpful and will be identified as necessary.

A first step 201 of process flow 200 is to provide the wafer having the devices to be tested. For example, wafer 150 is provided having a plurality of processors 102 formed thereon. As mentioned earlier, wafer 150 may or may not include a plurality of bumps 154 as shown in FIGs. 4 and 5. A second step 202 is to provide a test substrate 164 having test integrated circuits mounted thereon. For example, as previously described, a high speed integrated circuit 104 and a high speed integrated circuit 106 can be mounted to a test substrate 164. In one form, the integrated circuits included on the test substrate are functionally equivalent to chips which will be included in a multichip module along with the device under test. In another embodiment, the integrated circuits on the test substrate are customized test chips which are made specifically for performing a testing operation. As illustrated, and in a preferred embodiment, the integrated circuits are flip chip mounted to the test substrate, although other methods for establishing electrical connections between the integrated circuits and the test substrate can instead be used.

In a next step 204, the test substrate is incorporated into a test or probe assembly 160. Then, this probe assembly is electrically coupled to a tester in accordance with a step 205. While a particular probe assembly has been described in reference to FIGs. 4 and 5, these particular elements are not necessary elements of a test or probe assembly, but are merely shown as representative elements of the preferred embodiment. Any means for providing electrical connections from a tester to a device under test via test substrate 164 having integrated circuits thereon is suitable. Furthermore, there is no restriction as to the type of tester which is used.

After providing the semiconductor wafer to be probed and the probe assembly which is coupled to a tester, preferably one device from the wafer is brought into electrical contact with appropriate contacts of the probe assembly, as represented by a step 206 of process flow 200. It is noted that multiple devices could be tested at one time for improved throughput with only slight modifications to the probe assembly (e.g. by including multiple probe heads, multiple test substrates and/or deselection circuits on the integrated circuits on the test substrate), but for purposes of simplicity single device testing is hereafter described. In reference to FIG. 5, step 206 is achieved by bringing one of processors 102 of wafer 150 into electrical contact with probe wires 184 of array probe head 168. If desired, the wafer can be heated to a temperature above ambient so that elevated temperature testing can be performed to more closely match the operating environment in which the device under test will ultimately be placed or to test the device under extreme environmental conditions.

After electrical contact is made, the tester sends test vectors to the processor or device under test to insure that the basic function of the device under test is operational. In reference to process flow 200, this is represented as a step 208 of performing a basic internal functional test of processor 102. Basic functional testing includes, but is not limited to, testing for open circuits, short circuits, current leakage, basic instruction execution, stuck-at-fault testing, and communications between the various functional blocks of the device. The basic internal functional tests performed on processor 102 are performed via the tester sending test vectors directly to the processor, through a subset of the plurality of interconnects on test substrate 164. During this basic functional testing, the integrated circuits on the test substrate are preferably not in communication with the device under test. As a result of performing the internal functional testing, the device under test sends electrical signals back to the tester. These results are compared to expected results for satisfactory operation in a decision step 215. If the results are not as expected, the device under test is classified as faulty in accordance with a step 218. If the results are as expected, the device under test undergoes additional testing, for example testing of a high speed interface as explained below.

After performing the basic functional test and analyzing the results, a next step in accordance with the present invention is to perform testing of an external interface of the device or processor under test. This external interface testing is accomplished in process flow 200 by steps 220 and 221 of process flow 200. Specifically, to test the external interface, the tester loads test vectors into memory of the device under test, for example, into an instruction cache of a processor 102, as indicated in step 220. In step 221, the high speed interfaces between processor 102 and high speed integrated circuits 104 and 106 on test substrate 164 are tested. Stated otherwise, the tester loads test vectors into the device under test. These test vectors include test code. Upon receiving the test vectors, the device under test begins execution of instructions which are embedded in the test code. The embedded instructions include instructions which require the device under test to communicate with the integrated circuits on the test substrate, for instance load or store (read or write) instructions.

Communication between the device under test and integrated circuits 104 and 106 of the test substrate is initially attempted at a speed at the upper end of the frequency scale for the device under test. For example, if the expected maximum operating frequency of the device under test is 200 MHz, communication between the device under test and integrated circuits 104 and 106 is attempted at this frequency. If the result of the communication between the device under test and integrated circuits 104 and 106 is as predicted, as determined by a comparison of the result with the predicted result by the tester as described later, one can be assured that the device under test functions at this speed, and further can classify the operating frequency of the device. Such classification enables "speed sorting" to be done at wafer level, rather than waiting until final test as is done under current practices. If the response of the communication between the device under test and integrated circuits 104 and 106 is not as expected, another communication is made, but at a lower frequency. Again, the response to this communication is detected as a result, and if correct, the device under test is classified as having a functional operation at the lower frequency. If the result of the communication is not as expected, the frequency of the communication is again lowered, and the process is reiterated, until finally determining the actual speed of the interface between the device under test and integrated circuits 104 and 106, or determining that the interface is faulty.

If the interface has success in operating at least at a lower threshold frequency as a result of the test, the device passes a decision step 222 with a "No" and moves on to a next step (speed sorting step 223, as introduced above and as further explained below). If the device fails to operate at the lower threshold frequency, the answer to decision step 222 is "Yes" and the device is marked as faulty in step 218, whereby "faulty" simply means that the high speed interface of the device is faulty but that the device may be sold or otherwise disposed of with a reduced feature set.

The results of the communication between the device under test and integrated circuits 104 and 106 can be determined in any one of several ways. The results can be written into a register of the device under test which is read by the tester, and compared against an acceptable value stored in the tester. Alternatively, the results can be stored in memory of one of the integrated circuits 104 or 106 and read and compared by the tester. In another embodiment, the integrated circuits 104 and 106 can be used to read and compare a result which is stored in the device under test. These are but a few of numerous combinations which exist for analyzing the results of testing the high speed interface.

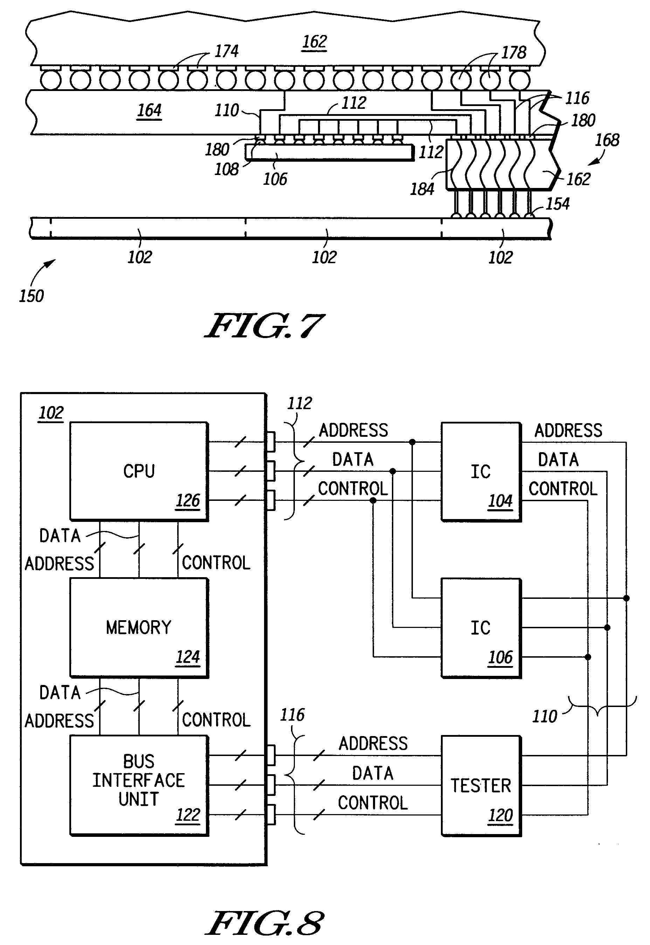

Steps 220 and 221 of process flow 200 can be further understood in reference to FIGs. 7 and 8. FIG. 7 is an exploded cross-sectional view of a portion of test substrate 164, which includes integrated circuit 106, a portion of array probe head 168, and a portion of semiconductor wafer 150. As illustrated in FIG. 7, test substrate 164 includes a plurality of electrical connections which are used to transmit electrical signals through the substrate. In a preferred embodiment, these connections are formed in test substrate 164 as a combination of conductive traces or lines, and conductive through holes formed in the test substrate. The particular manner in which these traces and through holes and pads are formed is not important for understanding the present invention, and is conventional in the formation of multilayer substrates known in the art. Further discussion is therefore omitted.

In accordance with one embodiment of the invention, the plurality of interconnects of test substrate 164 can be divided into three different subsets of connections, a first subset of these connections are interconnects which are used to transmit signals directly from the tester to integrated circuit 106. As illustrated in FIG. 7, one such interconnect is included in test substrate 164, and is illustrated as a conductive interconnect 110. Conductive interconnect 110 directly routes one conductive ball 178 which is electrically connected to probe card 162 to a conductive bump 108 on integrated circuit 106. Thus, signals from a tester can be sent directly through the test substrate to integrated circuit 106 without first being sent to the device under test. Likewise, signals can be sent from the integrated circuit 106 directly through the test substrate and to the tester without first being sent to the device under test.

A second subset of the plurality of connections within test substrate 164 are connections which are used to transmit signals from the tester directly to the device under test via array probe head 168. As illustrated in FIG. 7, connections are represented as conductive interconnects 116. Conductive interconnects 116 extend through test substrate 164 to connect some of conductive balls 178 which are in electrically contact with the probe card to probe wires 184 of the array probe head. Thus, signals from a tester can be sent directly through the test substrate to the device under test without first being sent to integrated circuit 106. Likewise, signals can be sent from the device under test directly through the test substrate and to the tester without first being sent to the integrated circuit 106. It is noted that this second subset of connections is not required for practicing the invention. For example, the integrated circuits on the test substrate could serve as the test engine for sending test vectors to and from a device under test which is a memory chip. Thereby eliminating the need for direct connection between the device under test and the tester.

Finally, a third subset of the plurality of connections within test substrate 164 are connections which used to transmit signals between integrated circuit 106 and the device under test. As illustrated in FIG. 7, this subset of the plurality of connections are referenced as conductive interconnects 112. Conductive interconnects permit electrical signals to be sent either to or from the integrated circuit 106 and either from or to, respectively, the device under test, without transmitting these signals to the tester.

The purpose of having the three different types of interconnects within test substrate 164 can be understood in reference to FIG. 8, which is a block diagram view of processor 102 and how as it communicates with integrated circuits 104 and 106 and with a tester 120. As illustrated, processor 102 includes a bus interface unit 122, a memory array 124, and a central processing unit (CPU) 126. Bus interface unit 122 of the processor is coupled to tester 120 via an address bus, a data bus, and a control bus, which collectively form interconnects 116 as illustrated. These buses or interconnects are used to send test vectors from the tester to the processor, as well as to send test results from the processor back to tester 120. Because these buses are being supplied with signals directly from tester 120, the maximum speed at which the signals can be transmitted will be governed by the capabilities of tester 120.

As explained previously, many of the processor interfaces being designed today operate at frequencies much higher than tester capabilities. Accordingly, there is a need to test the processors at higher speeds than what commercial testers offer. In accordance with the present invention, this is achieved by utilizing the processor itself to interface with integrated circuits 104 and 106 on test substrate 164. Upon receiving test vectors from tester 120, processor 102 begins execution by communicating with one or both of integrated circuits 104 and 106.
Communication is established via conductive interconnects 112 of test substrate 164. Again, conductive interconnects 112 include an address bus, a data bus, and a control bus which operate at a frequency higher than that of the tester. Because the processor or device under test is controlling the signals being sent to the integrated circuits 104 and 106, the speed at which these signals are sent is governed by the capability of the processor or device under test, which in many instances is faster than the speed at which signals can be sent from or received by the tester.

The results of the communications between processor 102 and integrated circuits 104 and 106 can be used to determine whether the processor properly functions at a particular communication frequency. For instance, if processor 102 executes instructions to read a particular memory address of integrated circuit 104 at a particular frequency, and store the contents of this address in a predetermined location within memory 124, whether this read operation was successful can be determined by comparing the contents of the predetermined location within memory 124 with an expected result. This comparison can be done by sending the contents to the tester via interconnects 116. Alternatively, the comparison can be done by using CPU 126 to compare the contents of the predetermined location within memory with another location in memory. In another embodiment, the comparison could be done by using one of integrated circuits 104 or 106 to do the comparison (if capable), in which case the results of the comparison can be sent from the integrated circuit directly to the tester via interconnects 110.

Not only can the results of communications between the device under test and integrated circuits 104 and 106 be used to determine proper functioning at one particular frequency, e.g. in steps 221 and 222, but can also be used to determine the maximum speed at which the device under test can operate. Determining the maximum operating frequency is known as speed sorting, and is included as a step 223 of process flow 200. After sending signals from processor 102 to integrated circuits 104 and 106, the speed at which these signals are successfully transmitted can be determined, thereby determining the operational speed of the processor interface. As an example, if integrated circuit 104 was a memory chip, processor 102 would attempt to communicate or write to the memory at a maximum frequency. To determine if this write operation was successful, the particular address location of the memory which was written to would be read either by the processor or by the tester. This value would be compared to an expected result. If the result matches that which was expected, the interface between processor 102 and the memory would be classified at that maximum frequency. If on the other hand, the result was not as expected, processor 102 would write to the memory at a lower frequency. A read operation would again be performed by either processor 102 or tester 120 to determine if the write operation performed as planned. If the result is not as expected, the frequency of the write operation continues to be reduced, until ultimately having the result of a read operation be as expected or determining that the interface is faulty (e.g. does not function within an allowable specification range). Upon achieving the expected result, the interface is specified at the frequency of the associated write operation.

After testing and speed sorting the device under test, a next step in process flow 200 is a decision step 224 which determines whether there are more devices on the wafer to be tested. If "Yes," steps 208, 215, 220, 221, 222, and 223 are repeated for each remaining device to be tested. (It is noted that if the test vectors are stored in the integrated circuits of the test substrate instead of in the device under test, there is no need to reload the test vectors from the tester, thereby reducing test time.) If there are no more devices to test, i.e. the answer to step 224 is "No," the devices tested go on to further processing. For instance, the individual devices are singulated from the wafer, e.g. by a sawing operation, in accordance with a step 226. Once singulated, devices which are determined as faulty either as a result of failing basic functional testing in step 215 or as result of not meeting a minimum specification level for the communication frequency of the high speed interface in step 222, the failing devices are discarded or disposed of as functional but without high speed interface capability. Passing devices, or those meeting basic functional requirements and meeting communication frequency specifications, are packaged in their final form. As an example, the passing devices can be packaged into a multichip module in a step 230 of process flow 200 according to their speed as determined in step 223.

The foregoing description and illustrations contained herein demonstrate many of the advantages associated with the present invention. In particular, it has been revealed that a semiconductor device can be tested at frequencies which are higher than the frequency at which a tester can operate. As a result, multimillion dollar testers of today can be replaced with less expensive testers which operate in conjunction with integrated circuits on a test substrate, and the useful lifetime of existing testers can be prolonged. The cost of including integrated circuits on the test substrate will be much less than the cost differential of utilizing the fastest tester model, with more accurate test results of the capabilities of the device under test. A further advantage of practicing the present invention is the inductance and capacitance which sometime effects test results is minimized because signals travel shorter distances (the integrated circuits included on the test substrate are closer to the device under test than the tester). Yet another advantages is that the present invention enables a semiconductor manufacturer to sell known-good-die (KGD) in the die or chip form with protective package. Many customers are interested in receiving integrated circuits in their unpackaged, die form, but manufacturers in the past have had to package the die to get reliable test information. The present invention eliminates the need for packaging die while instilling confidence as to the functionality, operability, and frequency of the die. Furthermore, the present invention facilitates higher yields and performance of multichip modules because the device under test can be tested for its interoperation with functionally equivalent integrated circuits to those that will be included in the multichip module with the device tested. As a result, if each chip to be included in a multichip module is tested in accordance with the present invention, the overall module yield can be significantly improved over conventional testing and packaging practices, such as those explained in reference to FIG. 3.

Thus it is apparent that there has been provided, in accordance with the invention, a method for high speed testing a semiconductor device that fully meets the need and advantages set forth previously. Although the invention has been described and illustrated with reference to specific embodiments thereof, it is not intended that the invention be limited to these illustrative embodiments. Those skilled in the art will recognize that modifications and variations can be made without departing from the spirit of the invention. For example, it is not necessary that the device under test be a processor or that the integrated circuits on the test substrate be memories. The device under test could be a memory, while a processor is included on the test substrate. Furthermore, the device under test could be a digital-to-analog converter (DAC) , and the integrated circuits on the test substrate could be an analog-to-digital converter (ADC) and a digital signal processor (DSP), where the DAC is tested using the DSP to send a digital signal to the DAC, using the ADC to convert the digital output of the DAC, and determining if the digital output from ADC matches the digital input to the DAC. Thus, the present invention is not limited to the functionality of either the device under test or the integrated circuits used in the test assembly.

It is also important to note that the present invention is not limited in any way to multichip module applications. While in one form, the integrated circuits included on the test substrate are functionally equivalent to co-packaged chips with the device under test in a multichip module, such is not a requirement of the invention. The integrated circuits on the test substrate could be custom designed programmable test chips. Moreover, programmable test chips can be designed to test for more than the external interface of the device under test. For example, circuitry could be included in the test chips to enable testing the device under test for basic internal functionality by testing for open circuits, short circuits, leakage, etc.

In addition, it is not a requirement that a tester communicate directly with the device under test to test high speed interfaces. For example, the tester could send test vectors to one of the integrated circuits included on the test substrate, which in turns executes instructions for communication across the high speed interface. Results of the communication could then be stored in the integrated circuit of the test substrate, and the tester reads the results from the integrated circuit rather than from memory. Thus, the tester need not directly communicate with the device under test to perform high speed testing. A benefit of this is that the tester need not be pin-for-pin compatible with the device under test, thereby lowering tester cost and size.

Furthermore, it is important to realize the present invention is not limited to testing devices while in wafer form. The die can be singulated from the wafer and still tested in accordance with the present invention. Moreover, the invention is not restricted to the point in the semiconductor manufacturing process at which the devices are tested. For instance, the testing can be performed just after wafer fabrication in place of conventional wafer probing, or the invention could be used as a final test of the device.

In view of all the numerous permutations, which are envisioned with the present invention, it is intended that the present invention encompass also variations and modifications as fall within the scope of the appended claims.

## Claims

1. A method of testing a semiconductor device comprising the steps of:
providing a device under test (102);
providing a tester;
providing a testing assembly (160) having:
an interface board (162) having a plurality of conductive traces (170) which interfaces with the tester;
a test substrate (164) having a plurality of interconnects (112, 116) electrically connected to the plurality of conductive traces on the interface board, wherein the plurality of interconnects includes a first subset (112) of interconnects and a second subset (116) of interconnects; and
an integrated circuit mounted to the test substrate and electrically connected to the first subset of the plurality of interconnects on the test substrate;
electrically connecting the device under test with the first and the second subsets of the plurality of interconnects of the test substrate;
using the tester to communicate test vectors to the device under test and instructing the device under test to begin execution of the test vectors, wherein the test vectors include code which instruct the device under test to communicate with the integrated circuit mounted to the test substrate; and
detecting a response to the communication between the device under test and the integrated circuit mounted to the test substrate to determine if the device under test meets a predetermined specification.

2. The method of claim 1 wherein the first subset of the plurality of interconnects on the test substrate is indirectly electrically connected to the interface board through the device under test.

3. The method of claim 1 wherein the tester has a capability of operating at a first frequency, and wherein communication between the device under test and the integrated circuit on the test substrate occurs at a second frequency that is higher than the first frequency.

4. The method of claim 1 wherein the device under test is one of a plurality of integrated circuit die on a semiconductor wafer.

5. The method of claim 1 wherein the device under test is a processor and wherein the integrated circuit on the test substrate is a memory.

6. The method of claim 1 wherein the device under test is a memory and wherein the integrated circuit on the test substrate is a processor.

7. The method of claim 1 further comprising the steps of:
packaging the device under test in a multichip module package which has as one of its chips a chip which is functionally equivalent to the integrated circuit mounted on the test substrate used during testing.

8. The method of claim 1 further comprising the step of determining a maximum operational frequency of the device under test using the response.

9. The method of claim 8 wherein the device under test is one of a plurality of integrated circuit die on a semiconductor wafer, and repeating the method of claim 1 to test each integrated circuit die on the semiconductor wafer, and wherein the step of determining is used to speed sort the plurality of integrated circuit die on the semiconductor wafer.

10. The method of claim 1 wherein the plurality of interconnects includes a third subset (110) of interconnects which directly electrically connect the integrated circuit mounted in the test substrate to the interface board.
